# EUROPEAN PATENT APPLICATION

(11) **EP 1 398 838 A1**
(43) Date of publication of application: **17.03.2004**
(21) Application number: 03447226.6
(22) Date of filing: 09.09.2003
(51) Int. Cl.: H01L 31/028, H01L 31/072, H01L 31/075

(54) **Photovoltaic device**

(30) Priority: 09.09.2002 EP 02447171; 19.09.2002 US 412101 P
(71) Applicant: Imec (Interuniversity Microelectronics Center) VZW, 3001 Leuven (BE); Fernuniversität Hagen, 58084 Hagen (DE)
(72) Inventor: Ulyashin, Alexander, 58085 Hagen (DE); Bilyalov, Renat, 3390 Tielt-Winge (BE); Poortmans, Jef, 3010 Kessel-Lo (BE); Fahrner, Wolfgang, 58097 Hagen (DE)
(74) Representative: Van Malderen, Joelle

(57) **Abstract**

The present invention concerns a photovoltaic device, comprising a first layer (1) of a first semiconductor material of a first conductivity type (1), a second layer (2) of a second semiconductor material of the opposite conductivity type of said first layer, and a third layer (3) of a third semiconductor material wherein:
said third layer (3) is located between said first layer (1) and said second layer (2); said third layer (3) is a porous translucent diffusion barrier.

## Description

### Field of the invention

The present invention is related to the field of photovoltaic devices.

### State of the art

Within photovoltaic research, one tends to develop cost-effective solar cells, which provide a high efficiency. The costs for producing for instance silicon material based solar cells can be divided into 3 parts: the material costs, which make up the biggest part and are strongly dependent on the quality of the used silicon, which is a function of its grain size, the solar cell process cost and the module process cost.

A certain type of cells, so-called HIT cell (Hetero junction with Intrinsic Thin-layer) are state of the art and were developed to improve the junction properties of the classical hetero junction cell.

US patent US 5,213,628 describes a photovoltaic device including an intrinsic amorphous semiconductor layer formed on a mono crystalline or polycrystalline semiconductor layer of one conductivity type, on which a amorphous semiconductor layer, being of the opposite conductivity type, is formed.

US patent US 5,066,340 describes a photovoltaic device including a crystalline silicon semiconductor layer of a first conductivity type material, an amorphous silicon semiconductor layer of the opposite conductivity type and a intrinsic micro crystalline silicon semiconductor layer between these 2 layers.

'Porous Silicon as an intermediate layer for thin-film solar cell', R. Bilyalov et a., Solar Energy Materials & Solar Cells 65 (2001) 477-485, describes the use of a dual porous silicon layer as an intermediate layer for thin-film solar cells. The porous layer has a thickness of 400 to 700 nm and serves as a seeding layer for epitaxial growth of silicon. The dual porous layer can be used for lift-off process. In both cases the porous layer is used outside of the active area of solar cell device.

In 'Transmission' electron microscopy investigation of the crystallographic quality of silicon films grown epitaxially on porous silicon' S. Jin et al., Journal of Crystal Growth 212 (2000) 119/127 a porous layer of 220 nm is disclosed with the same purpose.

JP03235371 describes the use of an intermediate porous layer to reduce the lattice mismatch between a GaAs layer and a Si layer, aiming at a reduction of lattice defects, which are present in the absence of this porous layer. A porous layer thickness is disclosed of larger than 100nm.

'Study and fabrication of PIN Photodiode by using ZnSe/PS/Si Structure', Chung C. Chang et al., IEEE transactions on electron devices, Vol. 47, No. 1, January 2000, describes a photodiode or photodetector based on compound material (ZnSe) and a porous silicon layer is used to allow high quality growth of ZnSe on a Si/porous Si structure.

'Amorphous/porous heterojunction on thin microcrystalline silicon', Alfredo Rubino et al., Journal of Non-Crystalline Solids 266-269 (2000) 1044-1048, describes the use of a porous layer in a LED device. An amorphous Silicon / porous silicon on microcrystalline silicon structure is disclosed The porous Si layer is used for photoluminescence (LED). Therefore it should be thick; values of 400nm to 1500 nm are disclosed for the thickness of the porous layer.

### Aims of the invention

The present invention aims to describe a novel solar cell, which combines a high efficiency and a low price. The invention contributes to the continuous efforts performed by industry to improve the quality of solar cells and reduce their production costs.

### Summary of the invention

The present invention concerns in a first aspect a photovoltaic device, comprising a first layer of a first semiconductor material of a first conductivity type, a second layer of a second semiconductor material of the opposite conductivity type of said first layer, and a third layer of a third semiconductor material wherein said third layer is located between said first layer and said second layer; said third layer is a porous translucent diffusion barrier.

Preferably, said third layer has a thickness between 1nm and 50nm. Said photovoltaic device can be a photodiode, a photoresistor or a solar cell. Said first, second and third semiconductor material are preferably single elementary semiconductor materials and more preferably selected from the group consisting of Si, Ge, GaAs. Advantageously, said first, second and third semiconductor material are silicon.

In a preferred embodiment of the present invention, the second semiconductor material and the third semiconductor material are based on the same chemical element or chemical element combination.

In another preferred embodiment of the present invention, the first semiconductor material and the second semiconductor material are based on the same chemical element or chemical element combination.

In yet another preferred embodiment of the present invention, the first semiconductor material, the second semiconductor material and the third semiconductor material are based on the same chemical element or chemical element combination.

The third semiconductor material is preferably non-doped and/or crystalline.

Said third layer can be based on material selected from the group consisting of multi crystalline semiconductor material and mono crystalline semiconductor material.

In the photovoltaic device according to the present invention, the second layer can be based on crystalline semiconductor material, is preferably based on material selected from the group consisting of mono crystalline semiconductor material and multi crystalline semiconductor material.

Said first layer preferably has a thickness between 3nm and 100nm.

In a preferred embodiment of the present invention, a photovoltaic device is disclosed, whereby the second layer is further attached to a fourth layer which is porous and based on a fourth semiconductor material, said fourth semiconductor material being non-doped crystalline silicon semiconductor material, and said fourth layer being attached to a fifth layer based on material selected from the group consisting of amorphous silicon semiconductor material, nano crystalline semiconductor material and micro crystalline silicon semiconductor material, said fifth layer being of the same conductivity type as the said second layer.

A surface of said second layer in the photovoltaic device according to the invention can be textured.

The photovoltaic device according to the invention can further comprise a layer of an amorphous semiconductor between said first and said third layer.

In a second aspect of the present invention, a method for providing a photovoltaic device is disclosed, said method comprising the steps of:
- providing a second layer of a second semiconductor material of a second conductivity type; and
- fabrication or deposition of a third layer of a third semiconductor material on said second layer, wherein said third layer is a porous translucent diffusion barrier, and
- depositing a first layer of a first semiconductor material of a first conductivity type on said third layer.

The method according to the present invention can further comprise the steps of:
- depositing a fourth layer which is porous and based on a fourth semiconductor material, said fourth semiconductor material being non-doped crystalline silicon semiconductor material,
- depositing a fifth layer based on material selected from the group consisting of amorphous silicon semiconductor material, nano crystalline semiconductor material and micro crystalline silicon semiconductor material, said fifth layer being of the same conductivity type as the said second layer.

The method according the present invention can also further comprise the steps of texturing the surface of said second layer. Also, a layer of an amorphous semiconductor can be deposited between the first layer and the third layer.

### Short Description of Figures

Fig. 1 shows a schematic representation of an aspect of the invention.

Fig. 2 shows a schematic representation of another aspect of the invention.

Fig. 3 shows the relation between the short circuit current [*mA*/*cm*^{*2*}] and the thickness of porous layer.

Fig. 4 illustrates the relation between open circuit voltage [mV] versus thickness of porous layer.

Fig. 5 shows the relation between efficiency [%] and thickness of porous layer.

Fig. 6 shows the fill factor [%] values for different values of porous layer thickness.

Fig. 7 depicts a SEM-view of acid textured CZ-Si surface.

Fig. 8 shows the reflectance characteristics of the solar cells performed on acid-textured and CP133 polished surfaces.

Fig. 9 draws the IQE of the typical HJ solar cells on polished and textured substrates.

Fig. 10 shows the I-V characteristic of the best cell with porous Si barrier performed on the textured surface.

### Detailed description of the invention

The following description and examples illustrate preferred embodiments of the present invention in detail. Those of skill in the art will recognize that there are numerous variations and modifications of this invention that are encompassed by its scope. Accordingly, the description of preferred embodiments should not be deemed to limit the scope of the present invention.

For the purpose of this invention, the naming of crystals is based on their grain sizes, and is represented in Tab. 1. The term "crystalline silicon" refers to silicon of all crystal types except amorphous silicon.

**Tab. 1:**

| naming of crystals based on their grain sizes | |
|---|---|
| Grain size of silicon crystal | Name |
| Atomic size | Amorphous |
| <10 nm | Nano crystalline |
| <1 µm | Micro crystalline |
| <100 µm | Poly crystalline |
| <1 mm | Multi crystalline |
| Infinite | Mono crystalline |

For the purpose of this invention, semiconductor material can be, but is not limited to, Si: Silicon, Ge: Germanium, GaP: Gallium Phosphide, GaAs: Gallium Arsenide, InAs: Indium Arsenide, C: Diamond, GaSb: Gallium Antimonide, InSb: Indium Antimonide, InP: Indium Phosphide, GaAs₁₋ₓSbₓ: Gallium Arsenide Antimonide, AlₓGa₁-ₓAs: Aluminium Gallium Arsenide, GaₓIn₁₋ₓP: Gallium Indium Phosphide, GaₓIn₁₋ₓAs: Gallium Indium Arsenide, GaₓIn₁₋ₓSb: Gallium Indium Antimonide, InAs₁₋ₓSbₓ: Indium Arsenide Antimonide, GaₓIn₁₋ₓAs_{y}P_{1-y}: Gallium Indium Arsenide Phosphide, GaₓIn₁₋ₓAS_{y}Sb_{1-y}: Gallium Indium Arsenide Antimonide, GaN: Gallium Nitride, AlN: Aluminium Nitride, InN: Indium Nitride, whereby x and y are natural numbers. Preferably semiconductor material refers to typical solar cell materials as Si, Ge, GaAs. Preferably semiconductor material refer to single elementary semiconductor materials as e.g. Si, Ge, C. Most preferably it is Silicon.

For the purpose of this invention the wording '...semiconductor material ... based on...' is used to indicate the possibilities of:
(a) having impurities (called dopants in the art) typically introduced in the semiconductor material during doping procedures.
(b) having impurities in the semiconductor material that do not bring significant changes in the conductivity properties of the semiconductor material.

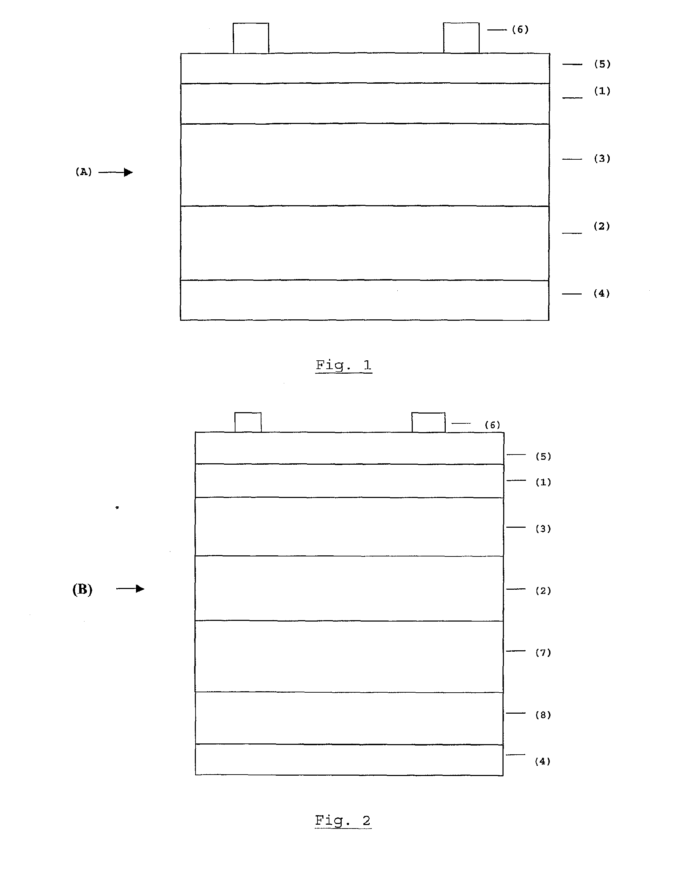

In a first aspect of the invention, a photovoltaic device is disclosed (Fig. 1, A) , comprising a first layer of a first semiconductor material of a first conductivity type (1), a second layer of a second semiconductor material of the opposite conductivity type (2) of the first layer, and a third layer made of porous semiconductor material (3) of a third semiconductor material, located between the first layer and the second layer. These three layers are preferably physically attached to each other. The first, second and third semiconductor materials can be based on the same chemical composition or can be based on a different composition. Preferably the second and third semiconductor materials are based on the same chemical composition. Most preferably the second and third semiconductor material are based on silicon.

In a typical production process the porous third layer can be created by elaboration of the second layer. The second layer can be, but is not limited to, a wafer or processed wafer. The first layer (called emitter layer in the art) can typically be covered with a conductive electrode layer (5), which can be transparent and can be used for the transport of photon-generated electrons towards the front contacts (6). The conductive electrode layer can be made of for instance Indium Tin Oxide (ITO), SnO₂ or ZnO. On the backside of the second layer (called bulk layer in the art) a back electrode is provided (4), which can be consisting of a. metal as for instance (but not limited to) Aluminum, Silver or Nickel. The backside of the bulk layer is defined as the one of the 2 surfaces of the bulk layer, which is the most distant from the third layer.

Porous semiconductor material is state-of-the-art. It is a medium consisting of semiconductor material and voids, where the percentage of the total volume occupied by voids can be typically between 10% and 85%. The terms n-type conductivity and p-type conductivity are known to a person ordinarily skilled in the art.

In a further embodiment of the first aspect of the present invention the third layer can be made of porous non-doped semiconductor material. Non-doped semiconductor material is semiconductor material, which has not explicitly been doped or has no characteristics similar to such material and is also referred to in the art as 'intrinsic semiconductor material'.

In another embodiment of the first aspect of the present invention the third layer is made of porous non-doped semiconductor material, which is based on crystalline semiconductor material. In another embodiment of the first aspect of the present invention the third layer is made of porous non-doped silicon semiconductor material, based on crystalline semiconductor material, with specific embodiments of having the third layer made from mono crystalline silicon semiconductor material or multi crystalline silicon semiconductor material.

According to a further embodiment of the first aspect of the present invention and possibly combined with any of the previously mentioned embodiments, the first layer is based on amorphous semiconductor material, nano crystalline semiconductor material or microcrystalline semiconductor material.

According to a further embodiment of the first aspect of the present invention and possibly combined with any of the previously mentioned embodiments, the second layer is based on crystalline semiconductor material, with specific embodiments of having the second layer based on mono crystalline or multi crystalline silicon semiconductor material.

In a further embodiment of the first aspect of the present invention, the second layer consists of multi crystalline silicon semiconductor material of p-type conductivity, the first layer is made of amorphous silicon semiconductor material of n-type conductivity, and the third layer is made of porous non-doped silicon semiconductor material based on multi crystalline semiconductor material between the first layer and the second layer.

The thickness of the first layer is preferably within the range of [3nm, 100nm]. The thickness of the third layer is preferably within the range of [1nm, 50nm]. The second layer has a typical appropriate bulk layer thickness.

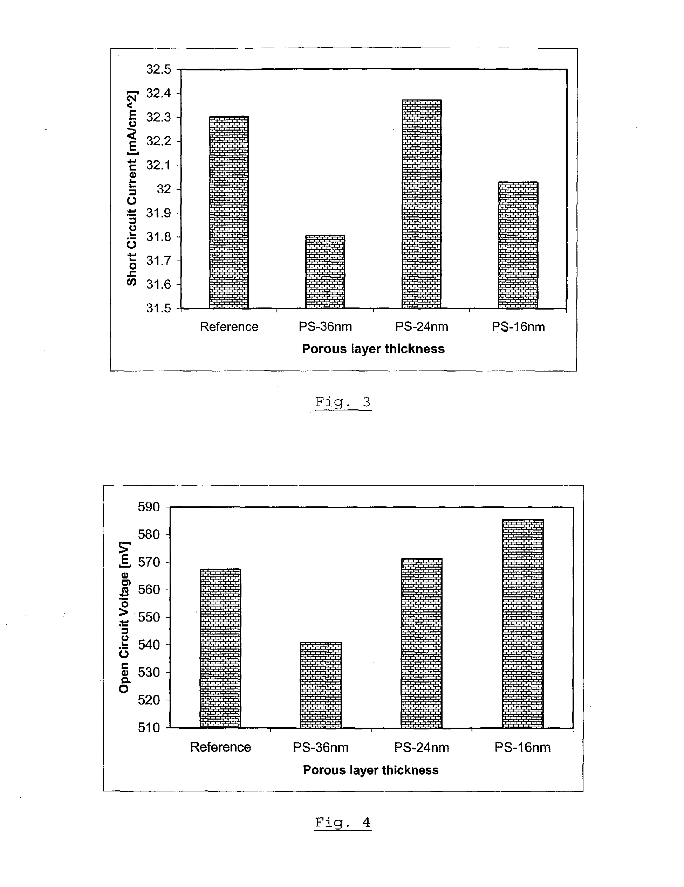

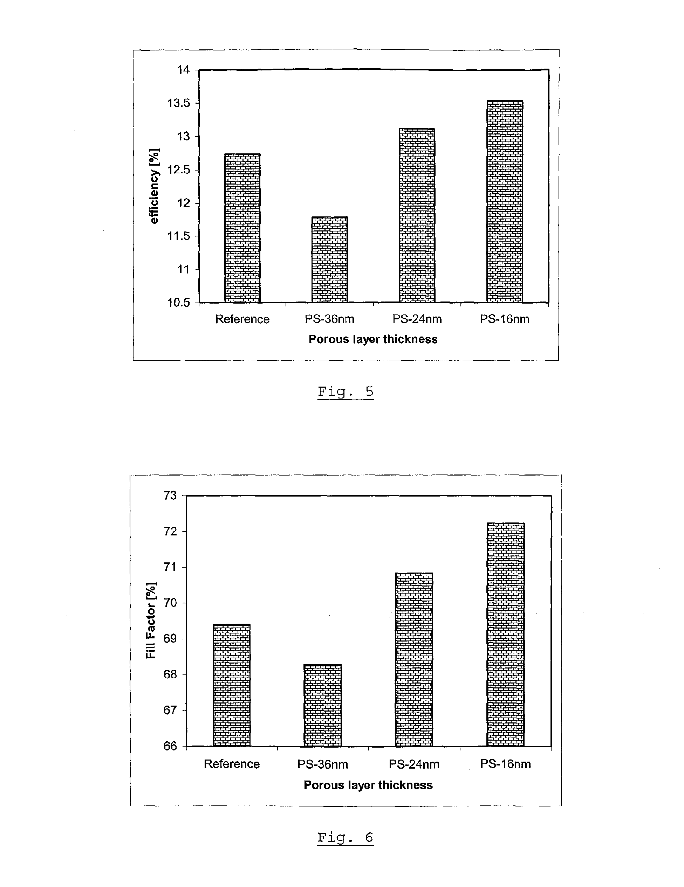

Fig. 3, Fig. 4, Fig. 5 and Fig. 6 are representing measurements of typical solar cell parameters as there are respectively the short circuit current *J*_{*sc*}[*mA*/*cm*²], the open circuit voltage *V*_{*oc*}[*mV*], efficiency *η*[%] and fill factor *FF* [%], based on typical but specific layer thicknesses for the emitter layer and the bulk layer, this for a reference, further mentioned below, and for different thicknesses of the porous layer: 16nm, 24nm, 36nm.

### Example 1:

A multi crystalline Silicon substrate (Baysix, carrier concentration of about 10¹⁶*cm*⁻³), on which a porous layer is electrochemically elaborated, having a thickness with a value between 15nm - 20nm and a porosity of about 20%. The remaining non-porous part of the wafer is p-doped. A PECVD process is used to deposit an amorphous silicon layer on top with a thickness of about 10-15 nm, which has been hydrogenated and n-doped. (carrier concentration of about 10¹⁹ *cm*⁻³).

The results indicate an optimal porous layer thickness to be preferably around 16nm, while for larger and smaller values the efficiency decreases, and indicate that the concept works for a thickness of the porous layer within the range of [1nm, 50nm] for typical emitter thickness, which is preferably within the range of [3nm, 100nm].

The efficiency is higher than in an prior art reference device where non-doped amorphous silicon was used for the third layer, as illustrated in Tab. 2.

The reference device consists of a p-doped multi crystalline Silicon wafer (Baysix, carrier concentration of about 10¹⁶*cm*^{*-3*}*),* on which a 5nm thick layer of intrinsic amorphous silicon is deposited via a PECVD technique. Another PECVD process is used to deposit an amorphous silicon layer on top with a thickness of about 10-15 nm, which has been hydrogenated and n-doped (carrier concentration of about 10¹⁹*cm*⁻³).

**Tab. 2:**

| comparison of characteristic parameters between the invention and an equivalent study with a non-doped amorphous third layer. | | | | |
|---|---|---|---|---|
| | *V*_{*oc*}*[mV]* | *J*_{*sc*}[*mA*/*cm*²] | *FF*[%] | η[%] |
| Invention | 579 | 32.63 | 75 | 14.2 |
| Amorphous non-doped silicon as thin film layer | 572.0 | 30.08 | 76.6 | 13.2 |

### Example 2:

A p-type, 10×10 cm² standard commercial substrate of Cz Si is used. Resistivity of the substrates is in the range 1-2 Qcm and crystallographic orientation is <100>. As a first step the sawing damages of as-received wafers are removed by a chemical etching using the chemical solution based on HF:HNO₃ acid mixture. Either CP133 solution which results in polishing of the Si surface or isotropic acid texturing leading to the surface texturisation can be used.

Porous silicon layers on the surface of wafers are produced in a standard Teflon cell using HF: acetic acid solution by anodization at a very low current densities less than 5 mA/cm² for a few seconds. Electrochemical reactions at these conditions provides the formation of porous Si layers with a very low porosity of 15-20% and the thickness in the range of 5-10 nm as measured by spectroscopic ellipsometry.

Tab. 3 shows the matrix of the wafers which are prepared prior to the a-Si:H layer deposition.

A standard RCA-I (sulfuric-acid/hydrogen-peroxide mixture (4:1, 80°C, 15 min)) with subsequent rinsing in DI wafer is used as the next cleaning step for all samples. Finally, before the insertion of wafers into the PECVD chamber they are dipped in HF (1%) for one minute.

**Tab. 3**

| p-type Cz-Si substrates prepared for HJ solar cell fabrication | | | |
|---|---|---|---|
| **Surface Treatment** | **Porous Si thickness (nm)** | **Porous Si porosity(%)** | **Wafer ID** |
| Polished | 0 | 0 | D0 |
| Polished | 5 | 15 | D1 |
| Polished | 10 | 20 | D2 |
| | | | |
| Textured | 0 | 0 | A0 |
| Textured | 5 | 15 | A1 |
| Textured | 5 | 25 | A2 |
| Textured | 10 | 15 | A3 |
| Textured | 10 | 25 | A4 |

Intrinsic a-Si:H layers with a thickness of 5 nm are deposited using 40 sccm flow rate for SiH₄ at 230°C substrate temperature in a conventional PECVD set up with the following parameters: 13.56 MHz frequency, 4.3 W power and 300 mTorr as a deposition pressure.

The deposition of the n-type a-Si:H with a thickness of 5 nm is done also at 230°C substrate temperature, 24 sccm flow rate of SiH₄ and 12 sccm of PH₃ diluted in SiH₄ (1% PH₃ in SiH₄).

ITO is deposited using a DC magnetron system with ITO target in argon ambient. The argon flow rate is 38 sccm and the DC plasma power is 100 W. Since an increase of the ITO deposition temperature lead to the decrease of the solar cell efficiency, the room temperature for the ITO deposition was used in our processing.

The front side (Cr/Ag, 30nm/4µm) and back side (Al, 2 µm) metallization processes are done with e-gun evaporation system. The heating during the metal evaporation does not exceed ~ 80 °C.

A simple solar cell structure consisting of a metal grid / ITO / (n)a-Si:H / (i)a-Si:H / (p)Cz-Si / Al is fabricated.

Nine 1×1 cm² test solar cells are performed on each (10×10 cm²) wafer. Separation of test solar cells was done using CO₂ laser.

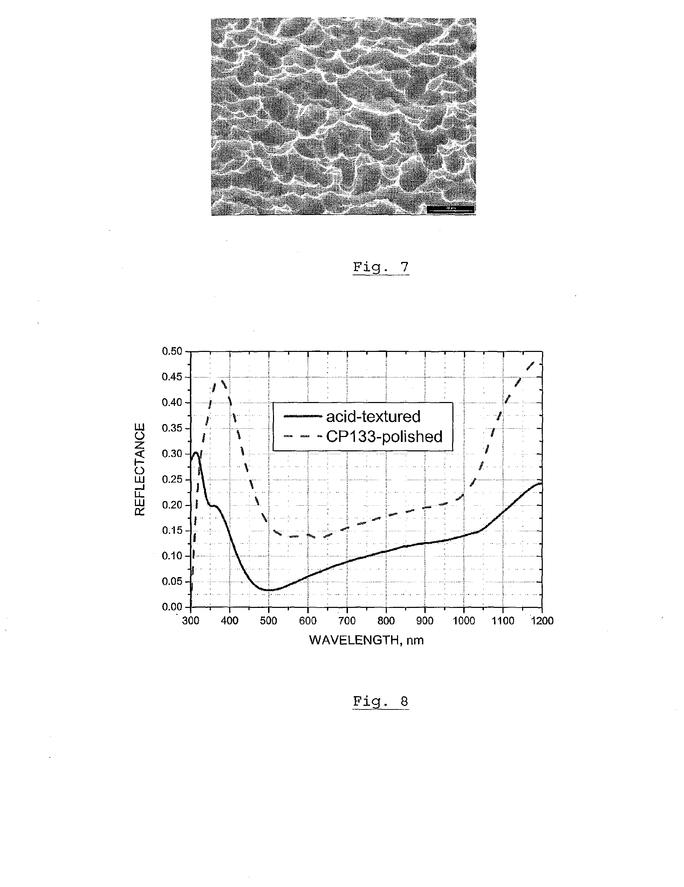

Fig. 7 shows a SEM view of the acid textured surface of p-type Cz-Si. As can be seen such a chemical treatment results in a formation of etch pits, which are uniformly distributed over the whole area.

One of the advantages of the acid texturing is formation of very fine etch pits with a diameter smaller than one micron within the macro-etch pits. Such surface serves as a better template than alkaline textured surface for further deposition of a-Si. Moreover this surface provides better light trapping than the alkaline textured surface.

Fig. 8 represents the reflectance characteristics of fully finished HJ solar cells performed on the acid textured and chemically polished surfaces.

The integral reflectance of the acid textured surface is 10% less than that from the polished one (9.7 % versus 19.5%). Particularly low reflectance is observed between 400 and 700 nm.

This is most likely the main reason for the enhancement of the HJ solar cell characteristics fabricated on acid-textured substrates as compared to those on CP133-polished samples. The Tab. 4 gives a summary of photovoltaic output parameters of these solar cells.

**Tab. 4:**

| average parameters of test (0.98 cm²) HJ solar cells processed on p-type Cz-Si substrates with different surface treatments (see Tab. 3). | | | | |
|---|---|---|---|---|
| **Wafer** | **J**_{**sc**} **(mA/cm**^{**2**}**)** | **V**_{**oc**}**(mV)** | **FF(%)** | **η(%)** |
| D0 | 30.07 | 594 | 77.8 | 14.0 |
| D1 | 30.93 | 596 | 78.6 | 14.5 |
| D2 | 30.71 | 592 | 77.8 | 14.2 |
| | | | | |
| A0 | 32.54 | 583 | 76.4 | 14.5 |
| A1 | 33.42 | 589 | 77.5 | 15.2 |
| A2 | 33.00 | 587 | 77.5 | 15.0 |
| A3 | 33.54 | 591 | 76.0 | 15.0 |
| A4 | 33.81 | 591 | 77.6 | 15.2 |

Data in Tab. 4 represent the average results of 9 solar cells performed on each 10x10 cm² wafer. It is obvious that the whole set of acid textured samples shows the higher short circuit current (due to the lower reflectance and the higher light trapping) and the lower open circuit voltage. It is believed that the reduction of V_{oc} is due to the increase of a surface recombination velocity on the textured surface or/and due to the worse p-n junction formation during the deposition of a very thin amorphous emitter on a macro-rough surface.

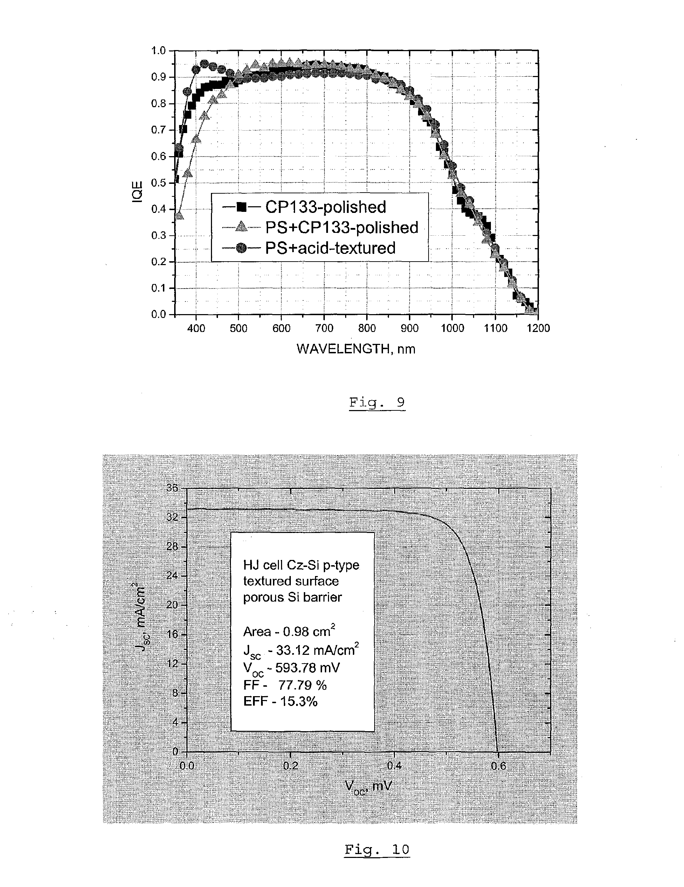

In order to investigate these suggestions IQE-analysis is applied on HJ solar cells. Fig. 9 shows the IQE-curves of the typical solar cells performed on textured and polished substrates.

As can be seen the IQE of all cells are almost identical in the visible and infrared regions while in the short wavelength region 350-500 nm there is a big difference. The peak which is demonstrated by the cell performed on acid-textured substrate cannot be attributed to the texturisation itself because the similar peaks we observed after low-temperature heating of HJ solar cells fabricated on polished substrates. It is believed that the hydrogen which is incorporated during the texturisation in the micro-pores diffuses during the solar cell processing and and improves properties of near the HJ-region. It is clear that the acid texturisation of the surface does not give rise to the surface recombination velocity and therefore the lower V_{oc} could be attributed to the non-ideal p-n junction profile due to the non-homogeneous deposition of a thin a-Si on the textured surface.

As follows from Tab. 4, independently from the kind of the substrate preparation the presence of a porous Si layer leads to the enhancement of the short circuit current. On the textured cells the same tendency could be clearly observed for the open circuit voltage. Moreover, it is interesting to note that the enhancement of the V_{oc} is related to the increase in the thickness of porous Si layer. This is an important fact taking into account that in our experiment an intrinsic a-Si layer was deposited. The same behavior of V_{oc} depending on porous Si intermediate layer we observed on multicrystalline Si but without the intrinsic layer. This confirms that porous Si as an additional barrier effectively prevents the diffusion of In/Sn from ITO into the substrate during the solar cell processing. Replacement of a porous Si buffer by a thicker intrinsic layer will obviously reduce characteristics of HJ cells due to the amorphous nature of this layer.

Slight increase of a porosity of the layer does not influence on V_{oc} because from one side increase of porosity leads to the increase of the gettering sites but on the other hands it increase diffusion along the pores. As a result we do not see any significant differences in photovoltaic characteristics of the cells with the increase of the porosity of porous Si barrier layers.

The cells performed on polished surface shiw the tendency that the presence of a such layer always slightly improves characteristics of a cell. It is noted that the behavior of a porous Si buffer layer is different for textured and non-textured surface as can be derived from IQE-curves in Fig. 9.

The best HJ solar cell from this set of experiment is realized on acid-textured substrate with porous Si intermediate layer of 10 nm thickness and porosity of 20%. The I-V characteristic of this cell is plotted in Fig. 10.

A first characteristic of the invention is that non-doped porous silicon based on crystalline silicon has electrical characteristics (carrier concentration is in the region of 10¹² *cm*⁻³ -10¹³ *cm*⁻³ ) similar to those of non-doped amorphous silicon (carrier concentration is in the region of 10¹¹*cm*⁻³)*,* more precisely it is not conductive, but it has lower absorption characteristics then amorphous silicon, which is important since the area for photogeneration of the carriers is located below the thin film layer - in this case porous silicon layer. A high transparency of the porous layer is preferred. The porous layer should be translucent. Non-doped amorphous silicon absorbs more light. This implies that the present invention can have a thicker third layer (in the art called 'thin film layer'), improving robustness against diffusion of Indium atoms coming from the ITO towards the bulk material. In other words the layer of non-doped porous silicon based on crystalline silicon has a function of diffusion barrier.

Moreover porous silicon is intrinsically hydrogen (H) rich, increasing passivation. Since grain boundaries between neighboring single crystals in a multi crystalline layer also increase recombination activity of the cell, it needs to be passivated. In the presence of Aluminium (Al), typically used as electrode material, H atoms coming from the porous silicon are diffusing quicker through the multi crystalline silicon and an improved passivation of the bulk material is achieved ['Synergetic effect of Aluminium and thermally treated porous silicon for bulk passivation of multi crystalline silicon', R. Bilyalov, Z. Matic, J. Poortmans, F. Schomann, W. Schmidt, Conference Record of the Twenty-Eighth IEEE Photovoltaic Specialists Conference - 2000 (Cat. No.00CH37036). IEEE, Piscataway, NJ, USA; 2000; xxxii+1838 pp. p.291-4].

Porous silicon can be achieved by electrochemical etching or chemical etching.

A second characteristic of the invention is that after the production of the porous layer by elaboration of the second layer, no extra plasma-cleaning step can be required before adding the amorphous emitter layer on top, which would be needed in case of a non-doped amorphous silicon thin film as third layer.

Moreover in the latter case a wet cleaning step is required before the PECVD process that deposits for instance the non-doped amorphous silicon thin film, which implies that the deposition of electrode material on the backside, typically Aluminium, can only be performed after the wet cleaning process, polluting the front surface. In the case of a non-doped porous thin film, where the porous layer is made through electrochemical etching this contamination will be removed during the production process.

In the case of a porous layer formed by chemical etching, the production of the device represented in Fig. 2, where the multi crystalline or mono crystalline bulk layer has to be on both sides covered with porous silicon material, can be simplified, since both layers can be formed simultaneously.

The invention also relates to a photovoltaic device (Fig. 2, B), whereby the second layer of (Fig. 1, A) is further attached to a fourth layer (7) made of porous non-doped silicon semiconductor material, based on crystalline semiconductor material, which is on its turn attached to a fifth layer (8) based on amorphous silicon semiconductor material and of the same conductivity type as the second layer, similar to the photovoltaic cell construction as in [Toru Sawada, Norihiro Terada, Sadaji Tsuge, Toshiaki Baba, Tsuyoshi Takahama, Kenichiro Wakisaka, Shinya Tsuda and Shoichi Nakano, High-efficiency a-Si/c-Si hetero junction solar cell, First WCPEC , Hawaii, 1994, pp. 1219-1226].

## Claims

1. A photovoltaic device, comprising a first layer (1) of a first semiconductor material of a first conductivity type (1), a second layer (2) of a second semiconductor material of the opposite conductivity type of said first layer, and a third layer (3) of a third semiconductor material wherein:
said third layer (3) is located between said first layer (1) and said second layer (2) ; said third layer (3) is a porous translucent diffusion barrier.

2. A photovoltaic device according to claim 1, wherein said third layer (3) has a thickness between 1nm and 50nm.

3. A photovoltaic device according to claim 1 to 2 wherein said photovoltaic device is a photodiode, a photoresistor or a solar cell.

4. The photovoltaic device according to claim 1 to 3, wherein said first, second and third semiconductor material are single elementary semiconductor materials.

5. The photovoltaic device according to claim 1 to 4, wherein said first, second and third semiconductor material are selected from the group consisting of [Si, Ge, GaAs].

6. The photovoltaic device according to claim 1 to 5, wherein said first, second and third semiconductor material are silicon.

7. The photovoltaic device according to claim 1 to 6, wherein the second semiconductor material and the third semiconductor material are based on the same chemical element or chemical element combination.

8. The photovoltaic device according to claim 1 to 7, wherein the first semiconductor material and the second semiconductor material are based on the same chemical element or chemical element combination.

9. The photovoltaic device according to claim 1 to 8, wherein the first semiconductor material, the second semiconductor material and the third semiconductor material are based on the same chemical element or chemical element combination.

10. The photovoltaic device according to claim 1 to 9, wherein the third semiconductor material is non-doped.

11. The photovoltaic device according to claim 1 to 10, wherein the third semiconductor material is crystalline.

12. The photovoltaic device according to claim 1 to 11, wherein said third layer (3) is based on material selected from the group consisting of multi crystalline semiconductor material and mono crystalline semiconductor material.

13. The photovoltaic device according to claim 1 to 12, wherein the second layer (2) is based on crystalline semiconductor material.

14. The photovoltaic device according to claim 1 to 13, wherein the second layer (2) is based on material selected from the group consisting of mono crystalline semiconductor material and multi crystalline semiconductor material.

15. The photovoltaic device according to claim 1 to 14, wherein the said first layer (1) has a thickness between 3nm and 100nm.

16. A photovoltaic device according to claim 1 to 15, whereby the second layer (2) is further attached to a fourth layer (7) which is porous and based on a fourth semiconductor material, said fourth semiconductor material being non-doped crystalline silicon semiconductor material, and said fourth layer (7) being attached to a fifth layer (8) based on material selected from the group consisting of amorphous silicon semiconductor material, nano crystalline semiconductor material and micro crystalline silicon semiconductor material, said fifth layer (8) being of the same conductivity type as the said second layer.

17. A photovoltaic device according to any of the claims 1 to 16, wherein a surface of said second layer is textured.

18. A photovoltaic device according to any of the claims 1 to 17, comprising a layer of an amorphous semiconductor between said first and said third layer.

19. A method for providing a photovoltaic device comprising the steps of:
- providing a second layer (2) of a second semiconductor material of a second conductivity type ; and
- fabrication or deposition of a third layer (3) of a third semiconductor material on said second layer (2), wherein said third layer (3) is a porous translucent diffusion barrier, and
- depositing a first layer (1) of a first semiconductor material of a first conductivity type (1) on said third layer (3) .

20. A method according to claim 19 further comprising the steps of:
- depositing a fourth layer (7) which is porous and based on a fourth semiconductor material, said fourth semiconductor material being non-doped crystalline silicon semiconductor material,
- depositing a fifth layer (8) based on material selected from the group consisting of amorphous silicon semiconductor material, nano crystalline semiconductor material and micro crystalline silicon semiconductor material, said fifth layer (8) being of the same conductivity type as the said second layer.

21. A method according to claim 19 or 20 further comprising the steps of texturing the surface of said second layer.

22. A method according to claim 19 or 20 further comprising the step of depositing a layer of an amorphous semiconductor before the step of depositing the first layer.
